# EUROPÄISCHE PATENTSCHRIFT

(11) **EP 2 765 528 B1**
(45) Veröffentlichungstag und Bekanntmachung des Hinweises auf die Patenterteilung: **14.11.2018**
(21) Anmeldenummer: 13154741.6
(22) Anmeldetag: 11.02.2013
(51) Int. Cl.: G06F 17/50

(54) **Wahlfreier Zugriff auf Signalwerte eines FPGA zur Laufzeit**
Unrestricted access to signal values of an FPGA during runtime
Accès libre à des valeurs de signal d'un FPGA pendant l'exécution

(43) Veröffentlichungstag der Anmeldung: 13.08.2014
(73) Patentinhaber: dSPACE digital signal processing and control engineering GmbH, 33102 Paderborn (DE)
(72) Erfinder: Kalte, Heiko, 33106 Paderborn (DE)

(56) Entgegenhaltungen:
- "Virtex FPGA Series Configuration and Readback. XAPP138 (v2.8)", Application Note:Virtex Series, 1. März 2005 (2005-03-01), Seiten 1-37, XP055067819, Gefunden im Internet: URL:http://www.xilinx.com/support/document ation/application_notes/xapp138.pdf [gefunden am 2013-06-21]
- M. A. Aguirre ET AL: "UNSHADES-1: An Advanced Tool for In-System Run-Time Hardware Debugging" In: "Field Programmable Logic and Application", 1. Januar 2003 (2003-01-01), Springer Berlin Heidelberg, Berlin, Heidelberg, XP055067816, ISSN: 0302-9743 ISBN: 978-3-54-045234-8 Bd. 2778, Seiten 1170-1173, DOI: 10.1007/978-3-540-45234-8_146, * Seite 1172 - Seite 1173 *
- J. Tombs ET AL: "The Implementation of a FPGA Hardware Debugger System with Minimal System Overhead" In: "Field Programmable Logic and Application", 1. Januar 2004 (2004-01-01), Springer Berlin Heidelberg, Berlin, Heidelberg, XP055067915, ISSN: 0302-9743 ISBN: 978-3-54-045234-8 Bd. 3203, Seiten 1062-1066, DOI: 10.1007/978-3-540-30117-2_127, * Seite 1063 *
- Paul Graham ET AL: "Improving the FPGA Design Process Through Determining and Applying Logical-to-Physical Design Mappings", , 1. Januar 2000 (2000-01-01), Seiten 1-12, XP055067891, Provo,UT,84602 Gefunden im Internet: URL:http://www.dtic.mil/cgi-bin/GetTRDoc?A D=ADA451583 [gefunden am 2013-06-21]

## Beschreibung

Die Echtzeitsimulation von komplexen, dynamischen Modellen stellt aufgrund der engen zeitlichen Randbedingungen selbst an moderne Rechenknoten hohe Anforderungen. In automotiven Hardware-in-the-Loop-Simulationen (HiL) werden solche Modelle vor allem dort eingesetzt, wo schnelle Regelkreise geschlossen werden müssen. Dies ist etwa bei der Simulation von Zylinderinnendrucksensoren der Fall, die bei der Verbrauchs- oder Abgasreduktion eine zunehmend größere Rolle spielen. Aber auch bei Regelstrecken die eine hohe Dynamik aufweisen, wie zum Beispiel bei Elektromotoren, sind kurze Zykluszeiten und geringe Latenzen unabdingbar. Diese können mit CPU-basierten Simulationen praktisch kaum mehr umgesetzt werden.

Field Programmable Gate Arrays (FPGAs) können Rechenknoten bei der Echtzeitsimulation unterstützen, indem sie die Berechnung von dynamischen Teilen eines Modells übernehmen. Durch die hohe Flexibilität und Möglichkeit der Parallelverarbeitung von Signalen lassen sich durch den Einsatz von FPGAs auch harte Echtzeitanforderungen leicht erfüllen. Die FPGAs können als Hardwarebeschleuniger für CPUs von Rechenknoten dienen. Eine solche Erweiterung für einen HiL-Simulator stellt beispielsweise das DS5203-FPGA Board von dSPACE dar. Entsprechend werden z.B. sehr dynamische Teile des Umgebungsmodells in das FPGA ausgelagert, so dass ausreichend präzise und schnelle Reaktionszeiten für das Steuergerät gewährleistet bleiben. Eine FPGA Hardware-Konfiguration wird üblicherweise basierend auf einem FPGA Modell in einer Hardwarebeschreibungssprache in einem Build-Prozess erzeugt.

Die Modelle einer Regelstrecke werden durch steigende Anforderungen an die Genauigkeit zunehmend komplexer und somit auch schwer handhabbar. Im automotiven Hil-Umfeld werden solche Modelle in der Regel mit dem Toolset Matlab/Simulink von The MathWorks Inc. erstellt. Simulink bietet eine blockbasierte Sicht in der Form eines Blockschaltbilds auf solche Modelle. Modellteile können in einem Blockschaltbild zu Subsystemen zusammengefasst und untereinander mit Signalen verknüpft werden. Der Datenfluss zwischen diesen Blöcken wird dabei über Signalleitungen dargestellt.

In einer CPU-basierenden Echtzeitsimulation wird das Blockschaltbild eines Modells mit Hilfe des Simulink Coders zunächst in C/C++ Quelldateien übersetzt. Diese werden anschließend über einen Compiler in eine ausführbare Applikation übersetzt, die auf einem Rechenknoten mit einem echtzeitfähigen Betriebssystem ausgeführt werden kann. Zusätzlich wird bei dem CPU-Build ein Trace-File erzeugt, welches ein Topologie File mit seiner grafischen Modellierung, beispielsweise in Simulink, darstellt.

Die Übersetzung eines Modells in eine CPU-Applikation hat zur Folge, dass die Berechnungen der Simulation sequenziell, in einer festen Schrittweite ausgeführt werden. Ein konsistentes Abbild aller Modellzustände oder Modell-Variablen, wie beispielsweise Daten auf den Signalleitungen oder Ein/Ausgabewerte der Blöcke, ist damit stets im Hauptspeicher des Rechenknoten vorhanden. Durch den direkten Zugang zum Hauptspeicher können die Modell-Variablen in einem Experimentiertool wie bspw. ControlDesk analysiert und/oder manipuliert werden. Ein wahlfreier Schreib-/Lese-Zugriff auf Variablen der HiL-Simulation ist möglich. Anhand des Trace Files können Signalwerte wie z.B. Motor-Drehzahl ausgewählt und durch eine Anzeige ausgeben oder manipuliert werden. Im HiL-Umfeld fasst man diese Vorgehensweise unter den Begriffen "Messen" und "Verstellen" zusammen.

Eine FPGA-basierte Simulation kann unter Zuhilfenahme des Xilinx System Generator (XSG) und des FPGA-Programming Blocksets von dSPACE, analog zur CPU-basierten Simulation, in einem Blockschaltbild mit Simulink modelliert werden.

Im Gegensatz zur CPU-Simulation wird dieses Modell allerdings nicht in eine iterative Programmiersprache übersetzt, sondern in eine Hardwarebeschreibungssprache, die eine kundenspezifische digitale Schaltung beschreibt. Die Beschreibung der kundenspezifischen Schaltung wird durch einen Syntheseprozess in einen FPGA-Konfigurationsdatenstrom übersetzt.

Für einige FPGAs ist es möglich, zu Debug-Zwecken den kompletten Zustand des FPGA einzufrieren und auszulesen. Durch das geschlossene Ein-/Ausgabeverhalten des FPGAs ist es jedoch nicht möglich, analog zum Hauptspeicher eines Rechenknotens beliebig auf Modellzustände zuzugreifen und diese ggf. zu verändern. Jede Modell-Variable, die der Anwender messen oder verstellen möchte, muss durch explizite Modellierung über Signalleitungen an die Schnittstellen des FPGAs geführt werden. Im Anschluss an diese Anpassung muss das Modell neu übersetzt werden, was mehrere Stunden dauern kann. Dieser Umstand kann zu sehr langen Entwicklungszyklen von FPGA-basierten Echtzeitsimulationen führen.

Das Dokument "Virtex FPGA Series Configuration and Readback. XAPP138 (v2.8)" offenbart ein Verfahren nach dem Oberbegriff des Anspruchs 1. Das Dokument von Paul Graham ET AL: "Improving the FPGA Design Process Through Determining and Applying Logicalto-Physical Design Mappings" offenbart ein Verfahren nach dem Oberbegriff des Anspruchs 6.

Ausgehend von dem oben genannten Stand der Technik liegt der Erfindung somit die Aufgabe zugrunde, ein Verfahren, eine Datenverarbeitungseinrichtung, ein Computerprogrammprodukt sowie ein digitales Speichermedium mit elektronisch auslesbaren Steuersignalen der oben genannten Art anzugeben, welche einen Zugriff auf Modell-Variablen im FPGA zur Laufzeit und eine Verkürzung von iterativen Entwicklungszyklen bei der Erstellung von FPGA-basierten Echtzeitsimulationen ermöglichen.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zum Zugriff auf einen Signalwert eines FPGA zur Laufzeit im unabhängigen Anspruch 1 angegeben.

Erfindungsgemäß ist ferner eine Datenverarbeitungseinrichtung mit einer Prozessoreinheit und einem FPGA angegeben, wobei die Datenverarbeitungseinrichtung zur Durchführung des obigen Verfahrens ausgeführt ist.

Erfindungsgemäß ist auch ein Computerprogrammprodukt mit Computer-implementierten Anweisungen, das nach dem Laden und Ausführen in einer geeigneten Datenverarbeitungseinrichtung die Schritte des obigen Verfahrens ausführt, angegeben.

Weiterhin ist erfindungsgemäß ein digitales Speichermedium mit elektronisch auslesbaren Steuersignalen angegeben, die so mit einer programmierbaren Datenverarbeitungseinrichtung zusammenwirken können, dass das obige Verfahren auf der Datenverarbeitungseinrichtung ausgeführt wird.

Grundidee der vorliegenden Erfindung ist es also, den Zugriff auf den Signalwert des FPGA zur Laufzeit zu ermöglichen, indem während des Betriebs des FPGA Zustandsdaten aus dem FPGA ausgelesen und der Signalwert daraus bestimmt wird. Die Zustandsdaten werden ausgelesen und nach Bedarf kombiniert, wobei strukturelle Änderungen an dem FPGA nicht erforderlich sind. Auch eine Unterbrechung des Betriebs des FPGA ist nicht erforderlich. Somit kann auf Signalwerte des FPGA wahlfrei zugegriffen werden. Der Zugriff auf die Signalwerte kann wie von der Ausführung einer Software bekannt erfolgen, inklusive des Zugriffs über Topologie Files (Trace File) und einer grafischen Modellierung mit Simulink. Signalwerte wie z.B. eine Motor-Drehzahl können entsprechend ausgewählt und angezeigt bzw. manipuliert werden.

Vorteilhafterweise sind für die Implementierung des FPGA keine Änderungen erforderlich, sodass der Bedarf an Ressourcen und Performance des FPGA unverändert ist. Entsprechend hat der Zugriff auf den Signalwert kein Einfluss auf den normalen Betrieb, weder in Hinsicht auf die erzeugte FPGA Hardware-Konfiguration noch während der Ausführung. Zustände verschiedener Modellvariablen können konsistent gespeichert werden, um einen Zugriff zu ermöglichen. Ein Zugriff auf gewünschte Signalwerte kann erfolgen, ohne dass eine angepasste FPGA Hardware-Konfiguration erzeugt und in das FPGA übertragen werden muss, wodurch Entwicklungszeiten verkürzt werden können. Einfluss auf verfügbaren Ressourcen und das Echtzeitverhalten des FPGA werden vermieden oder reduziert. Insbesondere können ohne Veränderung der FPGA Hardware-Konfiguration verschiedene Signalwerte aus dem FPGA nach Bedarf ausgelesen werden.

Die Konfigurationsebene betrifft eine logische Ebene des FPGA, die zur Initialisierung des FPGA dient. Während eines initialen Konfigurationsprozesses werden die Konfigurationsdaten in den Konfigurationsspeicher geschrieben, wodurch sich die funktionale Ebene im Anschluss wie modelliert verhält. Während des Betriebs können dann z.B. durch einen Trigger alle Registerinhalte der funktionalen Ebene zurück in die Konfigurationsebene gespiegelt werden. Der Inhalt des Konfigurationsspeichers kann anschließend ausgelesen werden, um daraus den Signalwert zu bestimmen. Die Auswahl des Signalwerts kann beliebig während der Laufzeit geändert werden. Bevorzugt erfolgt ein Zugriff auf eine Mehrzahl Signalwerte.

Die Rücklesedaten können eine beliebige Dateneinheit des FPGA beinhalten. Die Rücklesedaten können einzelne Registerwerte oder größere Speicherblöcke des FPGA umfassen. Die Speicherblöcke können beispielsweise Readback-Spalten des FPGA sein.

Die Reihenfolge des angegebenen Verfahrens kann prinzipiell variieren und ist nicht auf die hier angegebene Reihenfolge beschränkt.

Die Datenverarbeitungseinrichtung kann prinzipiell beliebig ausgeführt sein. Das FPGA ist typischerweise als Erweiterungsmodul in der Datenverarbeitungseinrichtung angeordnet oder mit dieser verbunden. Die Datenverarbeitungseinrichtung kann mit einem entfernten Steuerungsrechner über eine Datenverbindung verbunden sein. Besonders bevorzugt erfolgt ein Zugriff auf den Signalwert über eine Applikation auf dem Steuerungsrechner.

Die Darstellung des Signalwerts kann als graphische Darstellung erfolgen. Dabei kann der Signalwert vorzugsweise aus einer Liste per "Drag and Drop" auf dargestellte Instrumente zur Anzeige von Signalwerten gezogen werden.

Das Auslesen der Zustandsdaten aus dem Konfigurationsspeicher als Rücklesedaten beinhaltet keine Veränderung der Daten, sondern betrifft nur eine begriffliche Definition.

Das Bestimmen des Signalwertes aus den Rücklesedaten kann prinzipiell an beliebiger Stelle erfolgen, beispielsweise in dem FPGA, der CPU der Datenverarbeitungseinrichtung oder dem Steuerungsrechner. Entsprechend können die Zustandsdaten, die Registerdaten oder der Signalwert jeweils wie erforderlich übertragen werden.

Ein Zugriff auf den Konfigurationsspeicher des FPGA von außerhalb oder innerhalb des FPGA erfolgt über eine Schnittstelle. Eine übliche Architektur des Konfigurationsspeichers umfasst eine Schnittstelle mit 32 Bit Breite und einer Taktfrequenz von 100 MHz mit einer minimalen Auslesemenge von einem Frame. Damit ist eine Verwendung des Verfahrens im Sinne eines FPGA Debugger oder FPGA Scope mit einem zyklengenauen Zugriff im FPGA Takt mit heutzutage üblichen FPGAs nicht möglich. Ein Frame kann neben Registerwerten Informationen zu einer Look-Up Table sowie zur Multiplexer- bzw. Verdrahtungskonfiguration enthalten. Das Bestimmen des Signalwertes aus den Rücklesedaten umfasst vorzugsweise das Auffinden und Extrahieren von Registerwerten aus einem Frame.

In vorteilhafter Ausgestaltung der Erfindung umfasst der Schritt des Bestimmens des Signalwertes aus den Rücklesedaten das Abbilden der Rücklesedaten. Register stellen Speicher in der funktionalen Ebene dar, deren Daten einfach kopiert und zur Bestimmung des Signalwerts genutzt werden können. Dies ermöglicht die Identifikation der Daten zur Bestimmung des Signalwerts.

In vorteilhafter Ausgestaltung der Erfindung umfasst der Schritt des Bestimmens des Signalwertes aus den Rücklesedaten das Bestimmen des Signalwerts aus mehreren Registerwerten. Der Signalwert ist auf eine Mehrzahl Register verteilt, und die Inhalte der Register werden gemeinsam verarbeitet, um den Signalwert zu bestimmen.

In vorteilhafter Ausgestaltung der Erfindung umfasst der Schritt des Auslesens der Zustandsdaten aus dem Konfigurationsspeicher als Rücklesedaten das Ermitteln von für das Bestimmen des Signalwerts erforderlichen Bereichen des Konfigurationsspeichers und das Auslesen von Zustandsdaten der erforderlichen Bereiche des Konfigurationsspeichers als Rücklesedaten. Auszulesende Bereiche werden zur Laufzeit ermittelt, so dass der Zugriff auf den Konfigurationsspeicher ohne vorherige Anpassungen der FPGA Hardware-Konfiguration erfolgen kann. Durch das Ermitteln der erforderlichen Bereiche kann das Auslesen der Zustandsdaten auf diese Bereiche beschränkt werden, wodurch wenige Daten ausgelesen, übertragen und verarbeitet werden müssen.

In vorteilhafter Ausgestaltung der Erfindung umfasst der Schritt des Übertragens von Zustandsdaten aus einer funktionalen Ebene des FPGA in einen Konfigurationsspeicher in dessen Konfigurationsebene das Ermitteln von für das Bestimmen des Signalwerts erforderlichen Teilen der Zustandsdaten und das Sichern dieser Teile der Zustandsdaten in seinen Konfigurationsspeicher. Zu Übertragende Bereiche werden zur Laufzeit ermittelt, so dass das Übertragen der Zustandsdaten ohne vorherige Anpassungen der FPGA Hardware-Konfiguration erfolgen kann. Durch das Ermitteln der erforderlichen Bereiche kann das Sichern der Zustandsdaten auf diese Bereiche beschränkt werden, wodurch wenige Daten gesichert werden müssen.

In vorteilhafter Ausgestaltung der Erfindung umfasst der Schritt des Anforderns eines Signalwertes des FPGA das Bereitstellen einer Liste verfügbarer Signalwerte und die Auswahl eines Signalwerts aus dieser Liste. Die Liste kann prinzipiell zu einem beliebigen Zeitpunkt erstellt werden. Vorzugsweise wird die Liste unter Verwendung eines Modells der FPGA Hardware-Konfiguration erstellt. Besonders bevorzugt ist jedem Signalwert eine eindeutige Identifikationsnummer zugeordnet, über die der Zugriff erfolgt.

In vorteilhafter Ausgestaltung der Erfindung umfasst das Verfahren das Setzen eines Signalwertes zur Übertragung an das FPGA, das Bestimmen von Rückschreibedaten aus dem Signalwert, das Schreiben der Rückschreibedaten als Zustandsdaten in den Konfigurationsspeicher des FPGA, und das Übertragen der Zustandsdaten aus dem Konfigurationsspeicher in die funktionale Ebene des FPGA. Es ergibt sich in Analogie zu dem zuvor beschriebenen lesenden Zugriff auf das FPGA ein schreibender Zugriff. Dieser Zugriff erfolgt ebenfalls zur Laufzeit ohne Beeinflussung des FPGA. Die zuvor beschriebenen Details zum lesenden Zugriff auf das FPGA sind jeweils individuell entsprechend für den schreibenden Zugriff anwendbar.

Es erfolgt also eine dynamische, partielle Re-Konfiguration des FPGAs, wobei die jeweils relevanten Anteile im FPGA überschrieben werden. Dabei muss beispielsweise ein Simulink Konstant Block auf eine rekonfigurierbare Look-Up Table abgebildet werden. Diese kann anschließend mittels partieller, dynamischer Re-Konfiguration zur Veränderung eines beliebigen Signalwerts genutzt werden.

Bei dem Übertragen der Zustandsdaten in die funktionale Ebene des FPGA können die Rückschreibedaten zu dem Signalwert zusätzliche Informationen umfassen. Daher werden vorzugsweise zuerst die Zustandsdaten ausgelesen als Basis für die Rückschreibedaten, und der Signalwert wird in diese Zustandsdaten eingefügt. Damit wird die Datenintegrität des FPGA gewährleistet.

Erfindungsgemäß ist weiterhin ein Verfahren zum Durchführen eines FPGA Builds basierend auf einem FPGA Modell im Anspruch 6 angegeben.

Die Grundidee dieses Verfahrens ist also, bereits bei der Erstellung einer FPGA Hardware-Konfiguration erforderliche Daten über Signalwerte zu erfassen und derart zu verarbeiten, dass der Signalwert basierend auf erfassten Zustandsdaten zur Laufzeit des FPGA gebildet werden können. Speicherstellen sind vorzugsweise Register des FPGA. Register können im Modell explizit modelliert werden oder beispielsweise durch Blöcke mit Verzögerung implizit modelliert werden. Das Modell wird vorzugsweise graphisch erzeugt.

Die Reihenfolge des angegebenen Verfahrens kann prinzipiell variieren und ist nicht auf die hier angegebene Reihenfolge beschränkt. Beispielsweise kann das Erstellen einer Liste mit zur Laufzeit zugreifbaren Signalwerten ausgehend von dem Modell in der Hardwarebeschreibungssprache zu einem früheren Zeitpunkt erfolgen.

Vorzugsweise ist das hier angegebene Verfahren zum Durchführen eines FPGA Builds Teil eines Build-Verfahrens für eine Datenverarbeitungseinrichtung mit einem FPGA, wobei die Datenverarbeitungseinrichtung das FPGA umfasst oder damit verbunden ist. Bei diesem Verfahren wird zusätzlich ein Build für die CPU der Datenverarbeitungseinrichtung durchgeführt, wobei in einem CPU Trace File Generator eine Erzeugung eines CPU Trace Files erfolgt. Zusätzlich wird die Liste mit zur Laufzeit zugreifbaren Signalwerten und den dazu korrespondierenden Speicherstellen, die hier als "Logic Allocation File" bezeichnet ist, in ein maschinenlesbares File umgewandelt. Zusätzlich wird ein Trace File für das FPGA äquivalent zu dem Trace File der CPU erzeugt. In einem weiteren Schritt werden die Trace Files von CPU und FPGA in einem Trace File Merger zusammengefügt. Dadurch kann beispielsweise von einem Steuerungsrechner ein Zugriff auf Signalwerte unabhängig von der Implementierung für die Ausführung in der CPU oder dem FPGA erfolgen.

In vorteilhafter Ausgestaltung der Erfindung umfasst der Schritt des Erstellens einer Liste mit zugreifbaren Signalwerten und den dazu korrespondierenden Speicherstellen das Ermitteln einer Verknüpfung der Speicherstellen zur Bildung des Signalwerts. Die Liste enthält somit konkrete Angaben, wie ein Signalwert aus Zustandsdaten ermittelt wird.

In vorteilhafter Ausgestaltung der Erfindung umfasst das Verfahren den zusätzlichen Schritt des Erzeugens eines FPGA-Codes zum Bestimmen eines Signalwertes, wobei der FPGA-Code das Auslesen der Zustandsdaten aus dem Konfigurationsspeicher als Rücklesedaten und das Bestimmen des Signalwertes aus den Rücklesedaten basierend auf der Liste mit auslesbaren Signalwerten und den dazu korrespondierenden Speicherstellen umfasst. Eine anschließende Verarbeitung der Zustandsdaten zur Bestimmung des Signalwertes kann somit vollständig in dem FPGA durchgeführt werden. Entsprechend ist von dem FPGA nur der bestimmte Signalwert zu Übertragen, wodurch dessen Schnittstelle entlastet wird.

In vorteilhafter Ausgestaltung der Erfindung umfasst das Verfahren den zusätzlichen Schritt des Optimierens der FPGA Hardware-Konfiguration mit der Anordnung von Speicherstellen, die Zustandsdaten für einen Signalwert beinhalten, in einer Readback-Spalte des FPGA. Durch die Anordnung in einer Readback-Spalte wird der Zugriff auf die Zustandsdaten für einen Signalwert beschleunigt. Bei einer Anordnung aller Speicherstellen für einen Signalwert innerhalb einer Readback-Spalte kann darauf mit einer Operation zugegriffen werden. Es erfolgt somit eine Sortierung von Speicherstellen vor der Erzeugung der FPGA Hardware-Konfiguration.

Benachbarte Bereiche können eine einzelne Readback-Spalte des FPGA betreffen, oder eine Mehrzahl von benachbarten Readback-Spalten. Durch die benachbarte Anordnung wird der Zugriff auf die Speicherstellen beschleunigt. Bei einer Anordnung von Speicherstellen für zwei Signalwerte innerhalb einer Readback-Spalte kann auf beide mit einer Operation zugegriffen werden. Entsprechendes gilt für schreibende Zugriffe, wobei nur Signalwerte in das FPGA geschrieben werden können, die in einer Speicherstelle zumindest temporär darin vorliegen.

In vorteilhafter Ausgestaltung der Erfindung umfasst das Verfahren den zusätzlichen Schritt des Hinzufügens von Speicherstellen an Ausgängen von logischen Blöcken zur Bereitstellung von Zustandsdaten. Die Speicherstellen, üblicherweise Register, ermöglichen das Auslesen von Zustandsdaten, um daraus Signalwerte zu bestimmen. Bei erhöhter Anzahl von verfügbaren Zustandsdaten kann ein Zugriff auf eine erhöhte Anzahl Signalwerte erfolgen.

In vorteilhafter Ausgestaltung der Erfindung ist das FPGA ein Xilinx FPGA. Das Xilinx FPGA bietet neben der Möglichkeit der auch wiederholten Konfiguration des FPGAs ebenso die Möglichkeit des partiellen Auslesens und Konfigurierens des FPGAs während des Betriebs. Nachfolgend wird die Erfindung unter Bezugnahme auf die anliegende Zeichnung anhand bevorzugter Ausführungsformen näher erläutert.

Es zeigen
- Fig. 1: eine schematische Darstellung eines Datenverarbeitungssystems mit einem Steuerungsrechner und einem Echtzeitsystem,
- Fig. 2: eine Detailansicht eines FPGA des Echtzeitsystems aus Fig. 1,
- Fig. 3: ein Diagramm eines Verfahrens zur Durchführung eines Builds für das Echtzeitsystem aus Fig. 1,
- Fig. 4: eine Detailansicht eines FPGA Builds aus Fig. 3,
- Fig. 5: eine Detailansicht der Organisation des Konfigurationsspeichers des FPGA aus Fig. 2 in Readback-Spalten,
- Fig. 6: eine Schematische Darstellung von relevanten Speicherinhalten in Readback-Spalten des Konfigurationsspeicher, wobei die linke Darstellung eine Verteilung ohne Optimierung, die mittlere Darstellung eine Optimierung mit einer Konzentration von relevanten Speicherstellen in Readback-Spalten und die rechte Darstellung eine Optimierung mit einer benachbarten Anordnung von relevanten Readback-Spalten zeigt,
- Fig. 7: die Modellhafte Repräsentation aller für das Verfahren wichtigen Informationen, wie Hierarchie des FPGA Models, Bitbreiten und Binärpunkt Positionen der Signale, sowie die Adressinformationen der einzelnen Register im FPGA Konfigurationsspeicher,
- Fig. 8: eine Verteilung der Ergebnisse des Build Verfahrens aus Fig. 3 auf die verschiedenen Komponenten des Datenverarbeitungssystems aus Fig. 1.

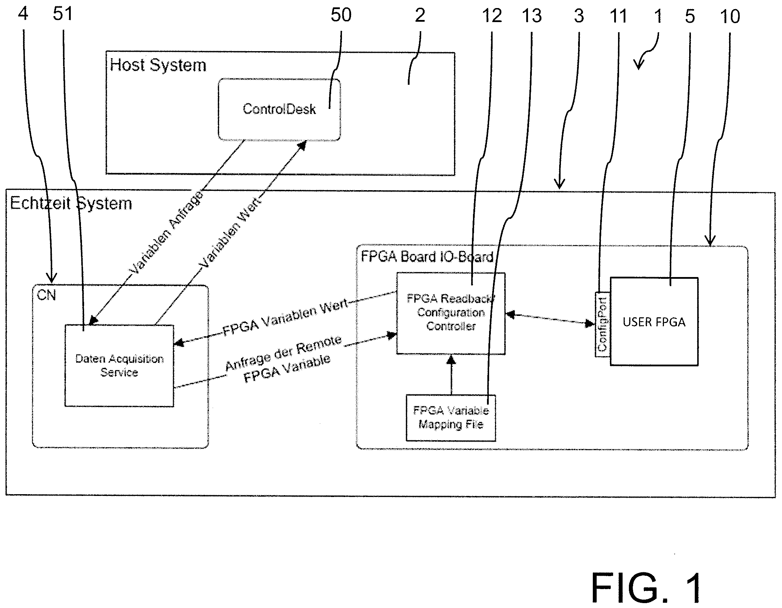

Die Figur 1 zeigt einen erfindungsgemäßen Aufbau eines Datenverarbeitungssystems 1 mit einem Steuerungsrechner 2, hier auch als Host-System gekennzeichnet, und einem Echtzeitsystem 3. Das Echtzeitsystem 3 ist mit dem Steuerungsrechner 2 über eine nicht explizit dargestellte Netzwerkverbindung verbunden.

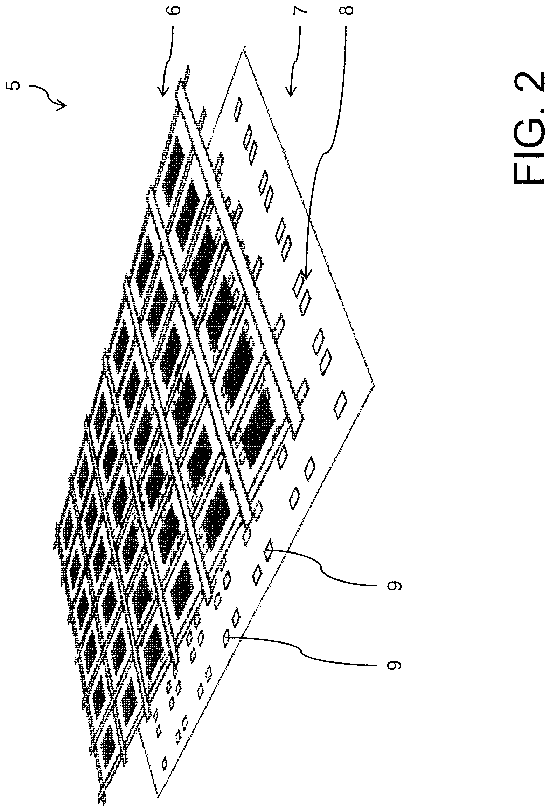

Das Echtzeitsystem 3 umfasst einem Rechenknoten 4, auch als CN gekennzeichnet, mit einer nicht dargestellten CPU sowie ein FPGA 5, das in diesem Ausführungsbeispiel ein Xilinx FPGA ist. Das Echtzeitsystem 3 ist hier eine beliebige Datenverarbeitungseinrichtung. Das FPGA 5 ist schematisch in Fig. 2 gezeigt und umfasst eine funktionale Ebene 6 und eine Konfigurationsebene 7. In der Konfigurationsebene 7 ist ein Konfigurationsspeicher 8 mit einer Mehrzahl Speicherstellen 9 angeordnet. Die Konfigurationsebene 7 ist eine logische Ebene des FPGA 5 zu dessen Initialisierung. Während eines initialen Konfigurationsprozesses werden Konfigurationsdaten in den Konfigurationsspeicher 8 geschrieben und in die funktionale Ebene 6 übertragen. Die Speicherstellen 9 entsprechen Registern des FPGA 5.

Das FPGA 5 ist auf einem FPGA-Board 10 angeordnet und über eine Schnittstelle 11 mit einem Controller 12 für den Zugriff auf die Schnittstelle 11 verbunden. Die Schnittstelle 11 hat hier eine Breite von 32 Bit bei einer Taktfrequenz von 100 MHz mit einer minimalen Auslesemenge von einem Frame. Ein Frame kann neben Registerwerten Informationen zu einer Look-Up Table sowie zur Multiplexer- bzw. Verdrahtungskonfiguration enthalten. Auf dem FPGA-Board 10 ist ein FPGA Variable Mapping File 13 für den Zugriff durch den Controller 12 gespeichert.

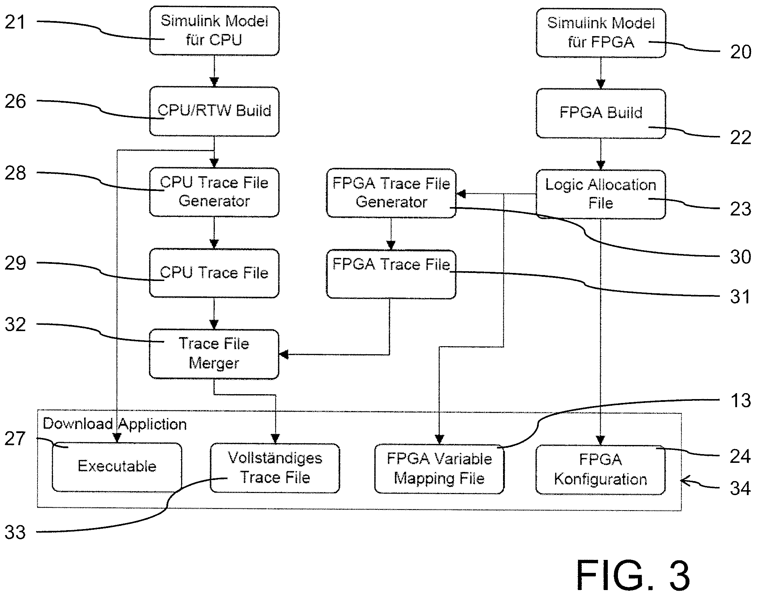

Für die Nutzung des Echtzeitsystems 3 wird wie im Folgenden unter Bezug auf Fig. 3 beschrieben ein Build durchgeführt. Als Ausgangsbasis für den Build dienen ein FPGA Modell 20 sowie ein CPU-Modell 21, die beide mit Simulink erzeugt wurden. Aus dem FPGA Modell 20 werden in einem FPGA Build 22 über VHDL, einer verbreiteten Hardwarebeschreibungssprache, ein Logic Allocation File 23 und eine FPGA Hardware-Konfiguration 24 erzeugt. In dem Logic Allocation File 24 wird eine Liste mit Speicherstellen 9 des Konfigurationsspeichers 8 für Zustandsdaten von zur Laufzeit in dem FPGA 5 zugreifbaren Signalwerten in dem gespeichert. Auch werden Verknüpfungen der Speicherstellen 9 zur Bildung der Signalwerte ermittelt und in dem Logic Allocation File 24 gespeichert, so dass ausgehend von dem Logic Allocation File 24 ein Signalwert aus Zustandsdaten bestimmt werden kann.

Aus dem Logic Allocation File 24 wird das bereits zuvor genannte maschinenlesbare FPGA Variable Mapping File 13 erzeugt, welches die Zuordnungen von Speicherstellen 9 zu Signalwerten in einer maschinenlesbaren Form enthält. Aus dem CPU Modell 21 wird in einem CPU Build 26 eine auf der CPU des Echzeitsystems 3 ausführbare Applikation 27 erstellt. In einem CPU Trace File Generator 28 wird außerdem ausgehend von dem CPU Build 26 ein CPU Trace File 29 erzeugt. Analog wird in einem FPGA Trace File Generator 30 ein FPGA Trace File 31 erzeugt. In einem weiteren Schritt werden die Trace Files 29, 31 in einem Trace File Merger 32 zu einem vollständigen Trace File 33 zusammengefügt.

Das Build Verfahren liefert als Gesamtergebnis eine Download Applikation 34 für das Echtzeitsystem 3 mit der Applikation 27, dem vollständigen Trace File 33, dem FPGA Variable Mapping File 13 und der FPGA Hardware-Konfiguration 24.

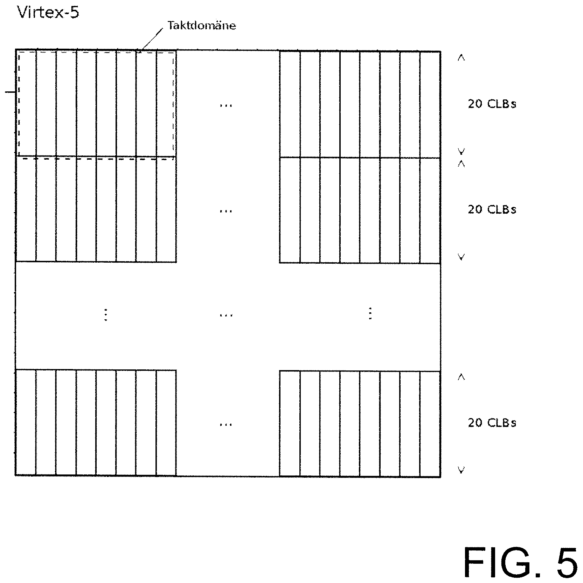

Der FPGA Build 22 ist im Detail in Fig. 4 gezeigt. Als Eingabe erhält der FPGA Build 22 ein Blockschaltbild 40 eines FPGA-Subsystems, welches eine Kombination von primitiven Blöcken wie Addition, Multiplikation, usw. umfassen. Das Ergebnis des Prozesses ist eine Model.ini-Datei 41, die den fertigen Bitstrom sowie eine Interfacebeschreibung enthält. Die Interfacebeschreibung enthält eine Liste aller Schnittstellen, die im FPGA-Subsystem instanziiert sind. Über diese Beschreibung können zu den FPGA-Schnittstellen korrespondierende CPU-Schnittstellen erzeugt werden. Im ersten Schritt des FPGA Build 22 wird aus dem Blockschaltbild 40 des FPGA-Subsystems durch Xilinx System Generator (XSG), eine HDL-Beschreibung 42 generiert, die in diesem Ausführungsbeispiel eine VHDL-Beschreibung ist. Diese Beschreibung wird anschließend durch ein Synthesewerkzeug in eine Netzliste übersetzt.

Die Netzliste des Simulink-Modells wird mit den übrigen für die Readback-Funktionalität notwendigen Readback-Framework-Komponenten 46 zu einer vollständigen Netzliste 47 zusammengeführt. Das gesamte Design wird anschließend durch einen Implementierungsprozess in einen Bitstrom übersetzt und in der Model.ini-Datei 41 abgelegt.

Zwischen den Blockausgängen des Simulink Blockschaltbilds und den FPGA-Komponenten (D-FlipFlops) bzw. den zu den FPGA-Komponenten gehörigen Speicherstellen 9 im Konfigurationsspeicher 8 wird eine Beziehung hergestellt. Diese Abbildung wird sukzessive während des FPGA Builds 22 aufgebaut bzw. verfeinert und vom FPGA Trace File Generator 30 in einem FPGA Trace File 31 abgelegt.

Wird das Blockschaltbild eines FPGA-Subsystems durch den XSG in eine HDL übersetzt, so sind diese beiden Beschreibungen im Bezug auf ihre Struktur ähnlich. Dies lässt sich nutzen, um eine direkte Relation zwischen z.B. einem Blockausgang eines Simulink-Blocks und Ports einer HDL-Entity zu erstellen.

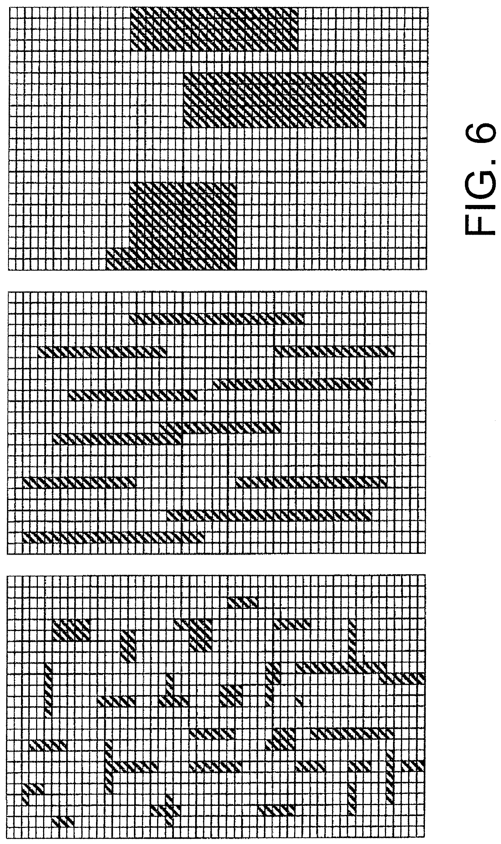

Das Verfahren umfasst zusätzlich das Optimieren der FPGA Hardware-Konfiguration 24 mit der Anordnung von Speicherstellen 9, die Zustandsdaten für einen Signalwert beinhalten, in einer Readback-Spalte des FPGA 5. Die Organisation des Konfigurationsspeichers 8 in Readback-Spalten ist in Fig. 5 gezeigt. Ein Frame umfasst eine 1-Bit breite und 1312-Bit lange Spalte im Konfigurationsspeicher 8 und erstreckt sich über eine CLB-Spalte der funktionalen Ebene 6. Eine Korrelation zwischen einem Bit innerhalb eines Frames und dem funktionalen Element, das es konfiguriert, kann durch die Xilinx Tools ermittelt werden. Zum Bestimmen eines Signalwerts ist somit nur ein Teil eines Frames von Interesse. Durch die Anordnung in einer Readback-Spalte wird der Zugriff auf die Zustandsdaten für einen Signalwert beschleunigt. Bei einer Anordnung aller Speicherstellen 9 für einen Signalwert innerhalb einer Readback-Spalte kann darauf mit einer Operation zugegriffen werden.

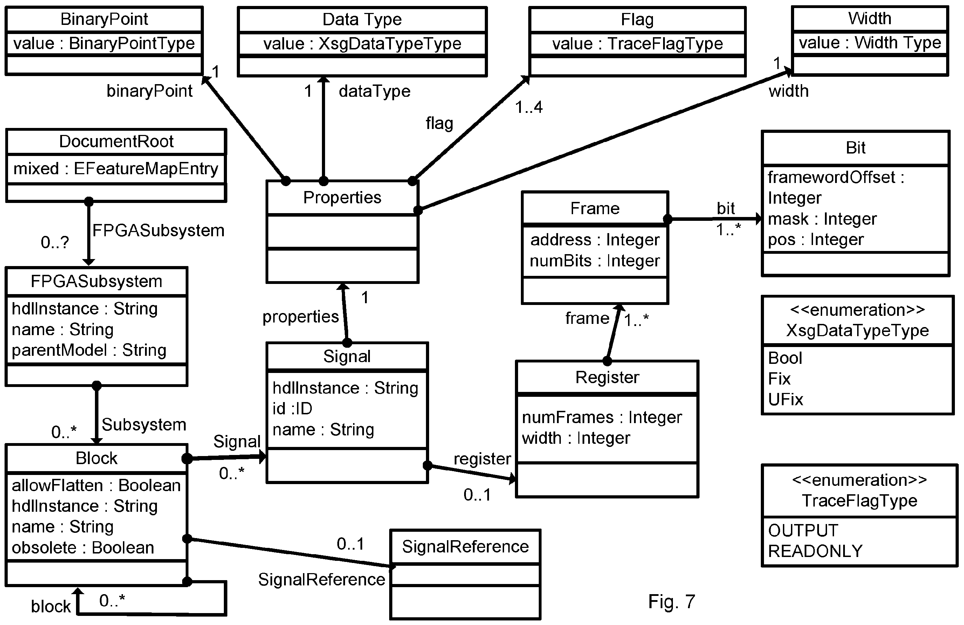

Wie in Fig. 6, linke Abbildung, gezeigt ist, sind relevante Readback-Spalten zunächst über den gesamten Konfigurationsspeicher 8 verteilt. Durch ein Optimieren der FPGA Hardware-Konfiguration 24 werden von Speicherstellen 9, die Zustände für einen Signalwert beinhalten, in benachbarten Bereichen des FPGA 5 angeordnet. Benachbarte Bereiche können eine einzelne Readback-Spalte des FPGA 5 betreffen, oder eine Mehrzahl von benachbarten Readback-Spalten. Durch die benachbarte Anordnung wird der Zugriff auf die Speicherstellen 9 beschleunigt. Durch eine Anordnung von Speicherstellen 9 für zwei Signalwerte innerhalb einer Readback-Spalte wird auf beide mit einer Operation zugegriffen. Fig. 6, mittlere Abbildung, zeigt eine Optimierung mit einer Konzentration von relevanten Speicherstellen 9 in einer reduzierten Anzahl von Readback-Spalten. Gemäß Fig. 6, rechte Abbildung, sind in einer weiteren Optimierung die relevanten Readback-Spalten zusätzlich benachbart in dem FPGA 5 angeordnet.

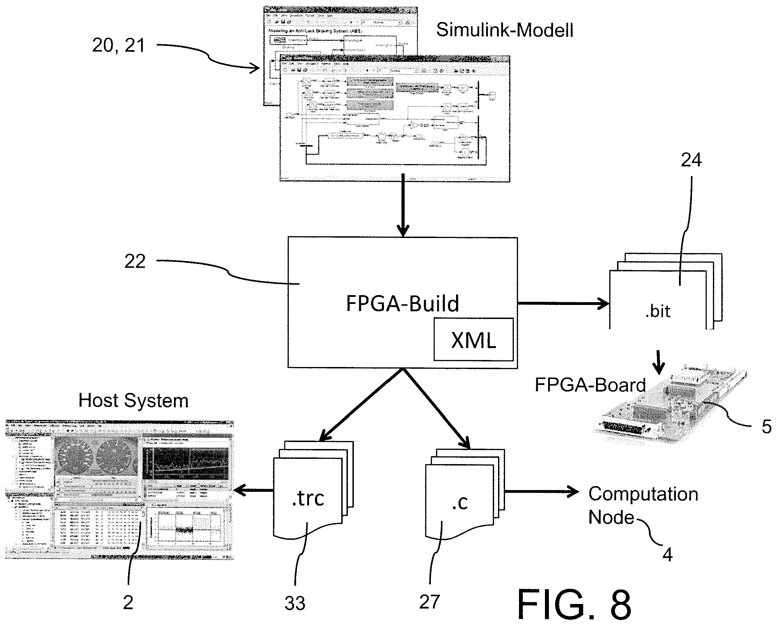

Eine Modellhafte Repräsentation aller für das Verfahren wichtigen Informationen, wie Hierarchie des FPGA Models, Bitbreiten und Binärpunkt Positionen der Signale, sowie die Adressinformationen der einzelnen Register im FPGA Konfigurationsspeicher ist in Fig. 7 dargestellt.

Ein Element vom Typ FPGASubsystem bildet die Wurzel jeder Readback-Modell Instanz. Das FPGA-Subsystem enthält in Anlehnung an die Modell-Hierarchie von Simulink rekursiv weitere Subsystem-Instanzen. Ein Subsystem kann in diesem Kontext sowohl als primitiver Block (z.B. Addierer), als auch als Simulink-Subsystem ausgeführt sein. Ein Name eines Subsystems bzw. Blocks und der Name der dazugehörigen HDL-Entity werden in den Eigenschaften name bzw. hdlInstance der Subsystem-Klasse gespeichert.

Jedes Subsystem kann mehrere Signale umfassen, welche Signale bzw. I/O-Ports im Simulink-Modell darstellen. Jedes Signal bekommt über die id-Eigenschaft einen eindeutigen Bezeichner. Da die Richtung der Signale (In/Out) keine Rolle spielt und Redundanzen bei der Modellierung zu vermeiden sind, stellt die Signal-Klasse per Konvention die Ausgänge der Blöcke bzw. Subsysteme im Simulink-Modell dar. Teilen sich mehre Subsysteme die gleichen Signale, kann über eine Instanz der SignalReference-Klasse auf Signale anderer Subsystem-Instanzen referenziert werden.

Ein Signal kann durch die Synthese mit einem Register assoziiert sein. Diese Assoziation findet sich ebenfalls zwischen der Signal- und Register-Klasse wieder. Die Beziehung zwischen einem Register und den Frames, in denen die Initialwerte des Registers gespeichert werden, wird über die entsprechenden Klassen modelliert. Die Eigenschaften eines Signal werden über die Properties-Klasse modelliert. Für das Zurücklesen und das anschließende Aufbereiten der Signale sind vor allem die Eigenschaften BinaryPoint, DataType und Width relevant.

Ein Register Element ist über die Frame-Klasse mit mehreren Bits assoziiert. Das Register verfügt, ebenso wie das Signal, über eine eigene width-Eigenschaft, da die Breite eines Signals und die Breite des dazugehörigen Registers unter Umständen variieren kann. Ein Bit gibt über die Bitposition (pos) zunächst an, um welches Bit des Registers es sich handelt. Außerdem enthält eine Bit-Instanz Informationen darüber, in welchem Wort (framewordOffset) innerhalb des Frames sich das Register-Bit befindet und mit welcher Bitmaske (mask) sich der Wert des Bits aus dem Framewort ausmaskieren lässt.

Das Readback-Modell ist in einer XML-Datei gespeichert. So kann das Modell toolübergreifend bearbeitet werden. Das Modell wird durch die Validierung gegen ein XSD-Schema syntaktisch und strukturell korrekt gehalten.

Das Verfahren umfasst den zusätzlichen Schritt des Erzeugens eines FPGA-Codes 44 als Readback Applikation zum Bestimmen eines Signalwertes, wobei der FPGA-Code 44 das Auslesen der Zustandsdaten aus dem Konfigurationsspeicher 8 als Rücklesedaten und das Bestimmen des Signalwertes aus den Rücklesedaten basierend auf der dem FPGA Variable Mapping File 13 umfasst.

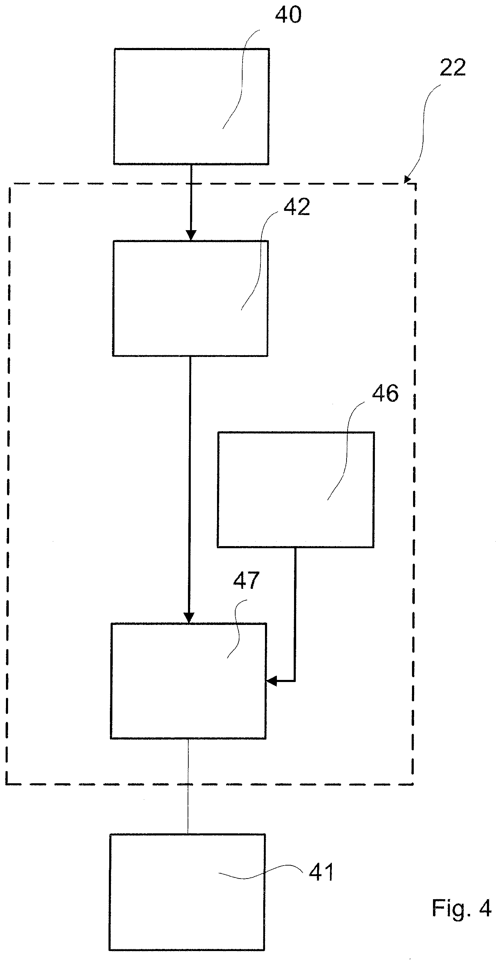

Fig. 8 zeigt die Verteilung der Ergebnisse des Build Verfahrens auf die verschiedenen Komponenten. Aus dem Simulink Modell 20, 21 wird ein Build mit einem FPGA Build 22 durchgeführt. Es wird eine FPGA Hardware-Konfiguration 24 erzeugt und auf das FPGA 5 geladen. Die Applikation 27 wird auf den Rechenknoten 4 geladen, und das vollständige Tracefile 33 wird an den Steuerungsrechner 2 übertragen.

Im Betrieb werden die FPGA Hardware Konfiguration 24 auf dem FPGA 5 gestartet und ausgeführt. Die Applikation 27 wird auf dem Rechenknoten 4 gestartet und ausgeführt. Auf dem Steuerungsrechner 2 wird eine Steuerungssoftware 50 gestartet, die in diesem Ausführungsbeispiel eine dSPACE ControlDesk Software ist. Das ControlDesk 50 kommuniziert mit dem Echtzeitsystem 3 über den Rechenknoten 4, wie in Fig. 1 gezeigt ist.

Zur Anzeige eines Signalwertes des FPGA 5 während der Laufzeit kann dieser über das ControlDesk 50 angefordert werden. Der Zugriff auf verschiedene Signalwerte erfolgt über das vollständige Trace File 33 und eine grafische Modellierung mit Simulink. Die Darstellung des Signalwerts erfolgt als graphische Darstellung, wobei der Signalwert aus einer Liste per "Drag and Drop" auf dargestellte Instrumente zur Anzeige von Signalwerten gezogen wird. Der Signalwert aus der Liste wird anhand einer eindeutigen Identifikationsnummer identifiziert.

Der Signalwert wird von dem ControlDesk 50 von dem Rechenknoten 4 angefordert. Dazu ist auf dem Rechenknoten 4 ein Data Acquisition Service 51 implementiert, der die Anforderung von dem ControlDesk 50 empfängt. Von dem Data Acquisition Service 51 wird der Signalwert von dem Controller 12 für den FPGA 5 angefordert. Dieser initiiert während des Betriebs des FPGA 5 das Übertragen von Zustandsdaten aus der funktionalen Ebene 6 des FPGA 5 in seinen Konfigurationsspeicher 8. Während des Betriebs werden so durch einen Trigger alle Registerinhalte der funktionalen Ebene 6 in die Konfigurationsebene 7 gespiegelt. In einer alternativen Ausführungsform werden aus dem FPGA Variable Mapping File 13 für das Bestimmen des Signalwerts erforderliche Teile der Zustandsdaten ermittelt und nur diese Teile in den Konfigurationsspeicher 8 gesichert.

Weiter werden in dem FPGA 5 von der Readback Applikation 44 Zustandsdaten aus dem Konfigurationsspeicher 8 als Rücklesedaten ausgelesen. Die ausgelesenen Rücklesedaten umfassen hier einen oder mehrere Frames, d.h. eine oder mehrere Readback-Spalten des FPGA 5. Dabei werden zunächst Readback-Spalten, die für das Bestimmen des Signalwerts erforderlich sind, ermittelt, und nur diese Readback-Spalten ausgelesen. Diese Informationen über die erforderlichen Readback-Spalten sind über das FPGA Variable Mapping File 13 zu ermitteln.

Basierend auf den Rücklesedaten wird in dem FPGA 5 der Signalwert bestimmt. Dazu werden Registerwerte aus den Frames gesucht und extrahiert. Die Informationen ergeben sich aus dem FPGA Variable Mapping File 13. Es erfolgt das Abbilden der Rücklesedaten. Dabei wird der Signalwert aus Zustandsdaten mehrerer Register gebildet.

Entsprechend werden die Inhalte der Register gemäß des FPGA Variable Mapping Files 13 gemeinsam verarbeitet, um den Signalwert zu bestimmen.

Der so bestimmte Signalwert wird über die Schnittstelle 11 des FPGA 5 an den Controller 12 übertragen, der den Signalwert über den Data Acquisition Service 51 des Rechenknotens 4 an das ContolDesk 50 des Steuerungsrechners 2 überträgt.

In Analogie zu dem vorhergehend beschriebenen lesenden Zugriff auf einen Signalwert des FPGA 5 ist auch ein schreibender Zugriff möglich. Dabei wird ein Signalwert zur Übertragung an das FPGA 5 ausgewählt. Aus dem Signalwert werden Rückschreibedaten bestimmt, die als Zustandsdaten in den Konfigurationsspeicher 8 des FPGA 5 übertragen werden. Aus dem Konfigurationsspeicher 8 werden die Zustandsdaten in die funktionale Ebene 6 des FPGA 5 übertragen. Die zuvor beschriebenen Details zum lesenden Zugriff auf das FPGA 5 sind jeweils individuell entsprechend für den schreibenden Zugriff anwendbar.

Das Verfahren ist als Computerprogrammprodukt mit Computer-implementierten Anweisungen implementiert, das nach dem Laden und Ausführen in dem Echtzeitsystem 3 die Schritte des obigen Verfahrens ausführt.

Ein digitales Speichermedium stellt elektronisch auslesbare Steuersignale bereit, die so mit dem Echtzeitsystem 3 zusammenwirken, dass das obige Verfahren auf dem Echtzeitsystem 3 ausgeführt wird.

**Bezugszeichenliste**

| | |
|---|---|
| Datenverarbeitungssystem | 1 |
| Steuerungsrechner | 2 |
| Echtzeitsystem, Datenverarbeitungseinrichtung | 3 |
| Rechenknoten | 4 |
| FPGA | 5 |
| funktionale Ebene | 6 |
| Konfigurationsebene | 7 |
| Konfigurationsspeicher | 8 |
| Speicherstellen | 9 |
| FPGA-Board | 10 |
| Schnittstelle | 11 |
| Controller | 12 |
| FPGA Variable Mapping File | 13 |
| FPGA Modell | 20 |
| CPU-Modell | 21 |
| FPGA Build | 22 |
| Logic Allocation File | 23 |
| FPGA Hardware-Konfiguration | 24 |
| CPU Build | 26 |
| Applikation | 27 |
| CPU Trace File Generator | 28 |
| CPU Trace File | 29 |
| FPGA Trace File Generator | 30 |
| FPGA Trace File | 31 |
| Trace File Merger | 32 |
| vollständiges Trace File | 33 |
| Blockschaltbild | 40 |
| Model.ini-Datei | 41 |
| HDL-Beschreibung | 42 |
| Readback File Generation | 43 |
| FPGA-Code, Readback Applikation | 44 |
| Readback-Framework-Komponenten | 46 |
| Netzliste | 47 |
| Steuerungssoftware, ControlDesk | 50 |
| Data Acquisition Service | 51 |

## Patentansprüche

1. Verfahren zum Zugriff auf einen Signalwert eines FPGA (5) zur Laufzeit, umfassend die Schritte
Laden einer FPGA Hardware Konfiguration (24) auf den FPGA (5),
Ausführen der FPGA Hardware Konfiguration (24) auf dem FPGA (5),
Anfordern eines Signalwertes des FPGA (5),
Übertragen von Zustandsdaten aus einer funktionalen Ebene (6) des FPGA (5) in einen Konfigurationsspeicher (8) in dessen Konfigurationsebene (7),
Auslesen der Zustandsdaten aus dem Konfigurationsspeicher (8) als Rücklesedaten, und
Bestimmen des Signalwertes aus den Rücklesedaten, **dadurch gekennzeichnet, dass** der Signalwert auf eine Mehrzahl Register des FPGA (5) verteilt ist, und
die Inhalte der Register in den Rücklesedaten gemeinsam verarbeitet werden, um den Signalwert zu bestimmen.

2. Verfahren nach einem der vorhergehenden Ansprüche, **dadurch gekennzeichnet, dass**
der Schritt des Auslesens der Zustandsdaten aus dem Konfigurationsspeicher (8) als Rücklesedaten das Ermitteln von für das Bestimmen des Signalwerts erforderlichen Bereichen des Konfigurationsspeichers (8) und das Auslesen von Zustandsdaten der erforderlichen Bereiche des Konfigurationsspeichers (8) als Rücklesedaten umfasst.

3. Verfahren nach einem der vorhergehenden Ansprüche, **dadurch gekennzeichnet, dass**
der Schritt des Übertragens von Zustandsdaten aus einer funktionalen Ebene (6) des FPGA (5) in einen Konfigurationsspeicher (8) in dessen Konfigurationsebene (7) das Ermitteln von für das Bestimmen des Signalwerts erforderlichen Teilen der Zustandsdaten und das Sichern dieser Teile der Zustandsdaten in seinen Konfigurationsspeicher (8) umfasst.

4. Verfahren nach einem der vorhergehenden Ansprüche, **dadurch gekennzeichnet, dass**
der Schritt des Anforderns eines Signalwertes des FPGA (5) das Bereitstellen einer Liste verfügbarer Signalwerte und die Auswahl eines Signalwerts aus dieser Liste umfasst.

5. Verfahren nach einem der vorhergehenden Ansprüche, umfassend die zusätzlichen Schritte
Setzen eines Signalwertes zur Übertragung an das FPGA (5),
Bestimmen von Rückschreibedaten aus dem Signalwert,
Schreiben der Rückschreibedaten als Zustandsdaten in den Konfigurationsspeicher (8) des FPGA (5), und
Übertragen der Zustandsdaten aus dem Konfigurationsspeicher (8) in die funktionale Ebene (6) des FPGA (5).

6. Verfahren zum Durchführen eines FPGA Builds basierend auf einem FPGA Modell (20) in einer Hardwarebeschreibungssprache, umfassend die Schritte
Erstellen einer FPGA Hardware-Konfiguration (24),
Ermitteln von Speicherstellen (9) eines Konfigurationsspeichers (8) für Zustandsdaten wenigstens eines Signalwerts basierend auf der FPGA Hardware-Konfiguration (24),
Erstellen einer Liste mit zur Laufzeit zugreifbaren Signalwerten und den dazu korrespondierenden Speicherstellen (9),
**gekennzeichnet durch** den zusätzlichen Schritt des
Optimierens der FPGA Hardware-Konfiguration mit der Anordnung von Speicherstellen (9), die Zustandsdaten für einen Signalwert beinhalten, in benachbarten Bereichen des FPGA (5),
wobei der Signalwert auf eine Mehrzahl Register des FPGA(5) verteilt ist.

7. Verfahren nach Anspruch 6, **dadurch gekennzeichnet, dass**
der Schritt des Erstellens einer Liste mit auslesbaren Signalwerten und den dazu korrespondierenden Speicherstellen (9) das Ermitteln einer Verknüpfung der Speicherstellen (9) zur Bildung des Signalwerts umfasst.

8. Verfahren nach dem vorhergehenden Anspruch 7 umfassend den zusätzlichen Schritt des
Erzeugens eines FPGA-Codes (44) zum Bestimmen eines Signalwertes, wobei der FPGA-Code (44) das Auslesen der Zustandsdaten aus dem Konfigurationsspeicher (8) als Rücklesedaten und das Bestimmen des Signalwertes aus den Rücklesedaten basierend auf der Liste mit auslesbaren Signalwerten und den dazu korrespondierenden Speicherstellen (9) umfasst.

9. Verfahren nach einem der vorhergehenden Ansprüche 6 bis 8 umfassend den zusätzlichen Schritt des
Optimierens der FPGA Hardware-Konfiguration mit der Anordnung von Speicherstellen (9), die Zustandsdaten für einen Signalwert beinhalten, in einer Readback-Spalte des FPGA (5).

10. Verfahren nach einem der vorhergehenden Ansprüche 6 bis 9 umfassend den zusätzlichen Schritt des
Hinzufügens von Speicherstellen (9) an Ausgängen von logischen Blöcken zur Bereitstellung von Zustandsdaten.

11. Datenverarbeitungseinrichtung (3) mit einer Prozessoreinheit und einem FPGA, wobei
die Datenverarbeitungseinrichtung (3) zur Durchführung des Verfahrens nach einem der Ansprüche 1 bis 5 ausgeführt ist.

12. Computerprogrammprodukt mit Computer-implementierten Anweisungen, das nach dem Laden und Ausführen in einer geeigneten Datenverarbeitungseinrichtung (3) die Schritte des Verfahrens nach einem der Ansprüche 1 bis 5 ausführt.

13. Digitales Speichermedium mit elektronisch auslesbaren Steuersignalen, die so mit einer programmierbaren Datenverarbeitungseinrichtung (3) zusammenwirken können, dass das Verfahren nach einem der Ansprüche 1 bis 5 auf einer Datenverarbeitungseinrichtung (3) ausgeführt wird.

## Claims

1. A method for accessing a signal value of an FPGA (5) during runtime, comprising the steps of
loading an FPGA hardware configuration (24) to the FPGA (5), executing the FPGA hardware configuration (24) on the FPGA (5),
requesting a signal value of the FPGA (5),
transferring state data from a functional level (6) of the FPGA (5) into a configuration memory (8) in the configuration level (7) thereof,
reading the state data from the configuration memory (8) as readback data, and
determining the signal value from the readback data,
**characterized in that**
the signal value is distributed over a plurality of registers of the FPGA (5), and
the contents of the registers in the readback data are processing jointly in order to determine the signal value.

2. The method according to any one of the preceding claims, **characterized in that**
the step of reading the state data from the configuration memory (8) as readback data comprises determining ranges of the configuration memory (8) required for determining the signal value and reading state data of the required ranges of the configuration memory (8) as readback data.

3. The method according to any one of the preceding claims, **characterized in that**
the step of transferring state data from a functional level (6) of the FPGA (5) into a configuration memory (8) in the configuration level (7) thereof comprises determining parts of the state data required for determining the signal value and saving said parts of the state data in the configuration memory (8) thereof.

4. The method according to any one of the preceding claims, **characterized in that**
the step of requesting a signal value of the FPGA (5) comprises providing a list of available signal values and selecting a signal value from said list.

5. The method according to any one of the preceding claims, comprising the additional steps of
setting a signal value for transferring to the FPGA (5), determining writeback data from the signal value, writing the writeback data as state data into the configuration memory (8) of the FPGA (5), and transferring the state data from the configuration memory (8) into the functional level (6) of the FPGA (5) .

6. A method for implementing an FPGA build based on an FPGA model (20) in a hardware description language, comprising the steps of
creating an FPGA hardware configuration (24),
determining memory locations (9) of a configuration memory (8) for state data of at least one signal value based on the FPGA hardware configuration (24),
creating a list having signal values accessible during runtime and the corresponding memory locations (9),
**characterized by** the additional step of
optimizing the FPGA hardware configuration by means of disposing memory locations (9) containing state data for a signal value in adjacent ranges of the FPGA (5), wherein the signal value is distributed across a plurality of registers of the FPGA (5).

7. The method according to claim 6, **characterized in that** the step of creating a list having readable signal values and the corresponding memory locations (9) comprises determining a linking of the memory locations (9) for forming the signal value.

8. The method according to the preceding claim 7, comprising the additional step of
generating an FPGA code (44) for determining a signal value, the FPGA code (44) comprising reading the state data from the configuration memory (8) as readback data and determining the signal value from the readback data based on the list having readable signal values and the corresponding memory locations (9) .

9. The method according to any one of the preceding claim 6 through 8, comprising the additional step of
optimizing the FPGA hardware configuration by means of disposing memory locations (9) containing state data for a signal value in a readback column of the FPGA (5).

10. The method according to any one of the preceding claim 6 through 9, comprising the additional step of
adding memory locations (9) at outputs of logical blocks for proving state data.

11. A data-processing device (3) having a processor unit and an FPGA,
wherein the data-processing device (3) is implemented for performing the method according to any one of the claims 1 through 5.

12. A computer program product having computer-implemented instructions and executing the steps of the method according to any one of the claims 1 through 5 after loading and executing in a suitable data-processing device (3).

13. A digital storage medium having electronically readable control signals able to interact with a programmable data-processing device (3) such that the method according to any one of the claims 1 through 5 is executed on the data-processing device (3).

## Revendications

1. Procédé pour accéder à une valeur de signal d'un FPGA (5) pendant le temps de marche, comprenant les étapes suivantes
charger une configuration (24) de matériel FPGA dans le FPGA (5),
exécuter la configuration (24) de matériel FPGA sur le FPGA (5),
demander une valeur de signal du FPGA (5),
transmettre des données d'état depuis un niveau fonctionnel (6) du FPGA (5) dans une mémoire de configuration (8) dans son niveau de configuration (7),
lire les données d'état depuis la mémoire de configuration (8) en tant que données de relecture, et
déterminer le valeur de signal depuis les données de
relecture, **caractérisé en ce que**
la valeur de signal est répartie sur une multitude de registres du FPGA (5), et
les contenus des registres dans les données de relecture sont traités conjointement afin de déterminer la valeur de signal.

2. Procédé selon l'une des revendications précédentes, **caractérisé en ce que**
l'étape de lecture des données d'état depuis la mémoire de configuration (8) en tant que données de relecture comprend la détermination de zones de mémoire de configuration (8) nécessaires pour la détermination de la valeur de signal et la lecture de données d'état des zones de mémoire de configuration (8) nécessaires en tant que données de relecture.

3. Procédé selon l'une des revendications précédentes, **caractérisé en ce que**
l'étape de transmission de données d'état depuis un niveau fonctionnel (6) du FPGA (5) dans une mémoire de configuration (8) dans son niveau de configuration (7) comprend la détermination de parties des données d'état nécessaires pour la détermination de la valeur de signal et la sauvegarde de ces parties des données d'état dans sa mémoire de configuration (8).

4. Procédé selon l'une des revendications précédentes, **caractérisé en ce que**
l'étape de demande d'une valeur de signal du FPGA (5) comprend la mise à disposition d'une liste de valeurs de signal disponibles et la sélection d'une valeur de signal dans cette liste.

5. Procédé selon l'une des revendications précédentes, comprenant les étapes supplémentaires suivantes
définir une valeur de signal en vue de la transmission au FPGA (5),
déterminer des données de réécriture depuis la valeur de signal,
écrire les données de réécriture en tant que données d'état dans la mémoire de configuration (8) du FPGA (5), et
transmettre les données d'état depuis la mémoire de configuration (8) dans le plan fonctionnel (6) du FPGA (5).

6. Procédé pour exécuter un numéro de compilation FPGA sur la base d'un modèle FPGA (20) dans un langage de description de matériel, comprenant les étapes suivantes
créer une configuration de matériel FPGA (24),
déterminer des positions de mémoire (9) d'une mémoire de configuration (8) pour des données d'état d'au moins une valeur de signal sur la base de la configuration de matériel FPGA (24), créer une liste de valeurs de signal accessibles pendant le temps de marche et des positions de mémoire (9) correspondantes, **caractérisé par** l'étape supplémentaire consistant à
optimiser la configuration de matériel FPGA par l'agencement de positions de mémoire (9) contenant des données d'état pour une valeur de signal dans des zones adjacentes du FPGA (5), sachant que la valeur de signal est répartie sur une multitude de registres du FPGA (5).

7. Procédé selon la revendication 6, **caractérisé en ce que** l'étape de création d'un liste avec des valeurs de signal lisibles et les positions de mémoire (9) correspondantes comprend la détermination d'une liaison des positions de mémoire (9) pour former la valeur de signal.

8. Procédé selon la revendication 7 précédente 7, comprenant l'étape supplémentaire consistant à
générer un code FPGA (44) pour déterminer une valeur de signal, sachant que le code FPGA (44) comprend la lecture des données d'état depuis la mémoire de configuration (8) en tant que données de relecture et la détermination de la valeur de signal depuis les données de relecture sur la base de la liste contenant des valeurs de signal lisibles et les positions de mémoire (9) correspondantes.

9. Procédé selon l'une des revendications 6 à 8 précédentes, comprenant l'étape supplémentaire consistant à
Optimiser la configuration de matériel FPGA par l'agencement de positions de mémoire (9) contenant des données d'état pour une valeur de signal dans une colonne de relecture du FPGA (5).

10. Procédé selon l'une des revendications 6 à 9 précédentes, comprenant l'étape supplémentaire consistant à
ajouter des positions de mémoire (9) aux sorties de blocs logiques afin de mettre à disposition des données d'état.

11. Dispositif de traitement de données (3) avec une unité de processeur et un FPGA, dans lequel
le dispositif de traitement de données (3) est réalisé pour exécuter le procédé selon l'une des revendications 1 à 5.

12. Produit de programme informatique avec des instructions implémentées sur ordinateur, qui, après le chargement et le lancement dans un dispositif (3) de traitement de données approprié, exécute les étapes du procédé selon l'une des revendications 1 à 5.

13. Support de stockage numérique avec des signaux de commande lisibles électroniquement, qui peuvent coopérer avec un dispositif (3) de traitement de données programmable de sorte que le procédé selon l'une des revendications 1 à 5 soit exécuté sur un dispositif (3) de traitement de données.
